# EUROPÄISCHE PATENTSCHRIFT

(11) **EP 0 642 159 B1**
(45) Veröffentlichungstag und Bekanntmachung des Hinweises auf die Patenterteilung: **03.02.1999**
(21) Anmeldenummer: 94113868.7
(22) Anmeldetag: 05.09.1994
(51) Int. Cl.: H01L 21/82, H01L 21/768, H01L 27/108

(54) **Herstellverfahren für ein Bitleitungskontaktloch einer Speicherzelle**
Method of manufacturing a bit line contact hole for a storage cell
Procédé de manufacture d'un contact pour la ligne de bit d'une cellule de stockage

(30) Priorität: 08.09.1993 DE 4330471
(43) Veröffentlichungstag der Anmeldung: 08.03.1995
(73) Patentinhaber: SIEMENS AKTIENGESELLSCHAFT, 80333 München (DE)
(72) Erfinder: Melzner, Hanno, Dipl.-Phys., D-85655 Grosshelfendorf (DE)

(56) Entgegenhaltungen:
- EP-A- 0 478 262
- US-A- 5 206 183
- PATENT ABSTRACTS OF JAPAN vol. 12, no. 320 (E-651) (3167) 30. August 1988 & JP-A-63 084 149 (HITACHI LTD) 14. April 1988
- PATENT ABSTRACTS OF JAPAN vol. 17, no. 672 (E-1474) 10. Dezember 1993 & JP-A-05 226 583 (NEC CORP) 3. August 1993
- PATENT ABSTRACTS OF JAPAN vol. 17, no. 514 (E-1433) 16. September 1993 & JP-A-05 136 124 (FUJITSU LTD) 1. Juni 1993

## Beschreibung

Die Erfindung betrifft ein Herstellverfahren für ein Bitleitungskontaktloch einer Speicherzelle in einem Halbleitersubstrat mit einem oberhalb eines MOS-Transistors angeordneten Kondensator, einer oberhalb des Kondensators angeordneten Bitleitung und einer unteren Kondensatorplatte, die mit einem ersten Source/Drain-Gebiet des Transistors verbunden ist.

Um bei DRAM-Speicherzellen eine hohe Integrationsdichte zu erzielen, sind Zellkonzepte vorteilhaft, bei denen die Bitleitung oberhalb eines als Stacked Capacitor ausgebildeten Kondensators angeordnet ist.

Die untere Kondensatorplatte ist mit einem ersten S/D-Gebiet des Transistors verbunden.

Dabei ergibt sich das Problem, den Bitleitungskontakt zu einem S/D-Gebiet des zugehörigen unterliegenden Transistors durch die Kondensatorebene hindurch herzustellen. Die Kondensatoren können nicht die gesamte Zellfläche beanspruchen, sondern müssen an einer Stelle Platz lassen für den Bitleitungskontakt, der eine, meist aber zwei Speicherzellen anschließt. Der Abstand der Kondensatoren von der Kante des Bitleitungskontaktlochs bestimmt also - neben der Größe des Kontaktlochs selbst - den effektiven Platzbedarf des Bitleitungskontaktes und sollte so gering wie möglich sein. Andererseits muß eine ausreichende Isolation zwischen der Bitleitung und der unteren Kondensatorplatte sowie der Zellplatte gewährleistet sein. Ferner wird ein Bitleitungskontakt angestrebt, der die Gateisolation und die Feldisolation überlappt, ohne daß bei der Herstellung diese Isolationen angegriffen werden.

In dem Artikel Itoh et.al.,VLSI Symposium 1991, Seite 9 ist ein Herstellungsverfahren für ein Bitleitungskontaktloch beschrieben, bei dem auf die Strukturierung der Zellplatte vor Abscheidung einer nachfolgenden Isolationsschicht verzichtet wird und zur Isolation ein Spacer an den Seitenwänden des Kontaktlochs erzeugt wird. Dadurch wird jedoch die tatsächliche Kontaktfläche stark verkleinert, da der Spacer mindestens die Dicke des notwendigen Isolationsabstandes besitzen muß. Eine Selbstjustage zum Gate und/oder Feldoxid ist nicht vorgesehen.

In dem Artikel von Küsters et. al., Journal de Physique, C4, Tome 49, septembre 1988, Seite C4-503 und in der Europäischen Anmeldung 0 258 657 desselben Erfinders ist offenbart, anstelle der Spacer-Bildung die freiliegende Kante der Zellplatte thermisch zu oxidieren, wodurch eine relativ große Kontaktfläche zur Verfügung steht.

Die japanische Anmeldung JP 2-79 462 sieht vor, bei einer DRAM-Speicherzelle des genannten Typs die Bitleitung über eine Pad-Elektrode an das S/D-Gebiet anzuschließen, die teilweise von den Kondensatorplatten überlappt werden kann. Die Zellplatte wird dabei mit einer Fototechnik strukturiert, so daß auch hier Justierfehler mit berücksichtigen werden müssen.

In der EP-0 478 262 A1 ist ein Verfahren zur Herstellung eines Bitleitungskontaktlochs in einer DRAM-Speicherzellenanordnung des genannten Typs beschrieben. Dabei werden die Zellplatte und das Kontakt loch mit Hilfe derselben Fotomaske strukturiert, eine Selbstjustierung des Kontaktlochs zum Gate ist durch eine Spacerbildung am Gate vorgesehen.

In der Veröffentlichung Pat. Abstracts of Japan, Band 17, Nr. 672 (E-1474), 2315 und der zugehörigen Anmeldung ist eine Speicherzelle der genannten Art beschrieben, bei der durch Ätzen von Vertiefungen in eine Isolierschicht die Fläche des darauf aufzubringenden Speicherkondensators vergrößert wird. Für die Herstellung des Bitleitungs-Kontaktlochs ist keinerlei Selbstjustierung vorgesehen.

Bei allen Verfahren ist eine Fototechnik zur Erzeugung des Bitleitungskontaktlochs notwendig, d. h. eine Fotolackschicht muß aufgebracht, belichtet und entwickelt werden, wobei Justiertoleranzen berücksichtigt werden müssen.

Der vorliegenden Erfindung liegt die Aufgabe zugrunde, bei einer Speicherzelle des genannten Typs ein Bitleitunskontaktloch ohne Einsatz einer Fototechnik herzustellen, wobei ein ausreichender Isolationsabstand zum Kondensator gewährleistet ist.

Diese Aufgabe wird durch ein Herstellverfahren mit den Merkmalen des Patentanspruchs 1 gelöst.

Die Erfindung sieht vor, die durch den Kondensator verursachte Topographie einer die Zellplatte bildenden leitenden Schicht zur Erzeugung einer Ätzmaske für das Bitleitungskontaktloch auszunutzen. Da das von der Bitleitung zu kontaktierende zweite S/D-Gebiet des Transistors nicht von der unteren Kondensatorplatte überdeckt ist, ist hier eine Vertiefung vorhanden. Die Ätzmaske wird nicht in der Vertiefung, sondern nur auf den erhabenen Stellen erzeugt und ist daher selbstjustiert zum zweiten S/D-Gebiet.

In einer Ausführungsform ist vorgesehen, daß der Abstand der unteren Kondensatorplatten benachbarter Speicherzellen über dem zweiten S/D-Gebiet größer ist als über dem übrigen Halbleitersubstrat, also z. B. über Isolationsgebieten, die benachbarte Speicherzellen voneinander isolieren. Die schmalen Abstände werden beim Aufbringen einer leitenden Schicht für die Zellplatte, im allgemeinen Polysilizium, aufgefüllt, während in den breiten Abständen, also über dem zweiten S/D-Gebiet, die Vertiefung erzeugt wird. Wird in die Vertiefung eine Hilfsstruktur eingebracht, kann auf der übrigen erhabenen Oberfläche eine Ätzmaske erzeugt werden, die dann selbstjustiert zu der Topographie erzeugenden unteren Kondensatorplatte ist.

Beispielsweise kann die Vertiefung mit einem Lackstöpsel als Hilfsstruktur versehen werden, indem ganzflächig Lack aufgebracht und rückgeätzt oder rückbelichtet wird, bis die erhabene Oberfläche der leitenden Schicht freiliegt. Die freiliegende Oberfläche kann nun in ein als Ätzmaske geeignetes Material umgewandelt werden ,z. B. durch einen Oxidations- oder Nitridierungsprozeß, wobei jedoch nicht die gesamte Schichtdicke der Zellplatte umgewandelt wird. Auf dem freiliegenden Polysilizium kann auch selektiv ein geeignetes Material abgeschieden werden. Die erhaltene Ätzmaske muß abhängig von der Selektivität des Ätzprozesses die vollständige Durchätzung der leitenden Schicht und eventuell bis zum Halbleitersubstrat ermöglichen.

Wird eine Oxydation zur Erzeugung der Ätzmaske eingesetzt, ist es vorteilhaft, vor Erzeugen der Lackstöpsel ganzflächig eine Hilfsschicht insbesondere aus Nitrid aufzubringen und mit den Lackstöpseln als Maske wieder zu entfernen. Nun können die Lackstöpsel entfernt werden, und in den Vertiefungen bleibt Siliziumnitrid als Oxydationsmaske.

Die Hilfsstruktur kann aus einem anderen, insbesondere temperaturfesten, Material hergestellt werden, und es kann dazu beispielsweise ein Schleifverfahren (Chemical Mechanical Polishing) eingesetzt werden.

Die Ätzmaske kann auf die erhabene Oberfläche der Zellplatte aufgebracht werden, z. B. mittels einer selektiven Abscheidung, wodurch z. T.auch die Temperaturbelastung verringert werden kann. Aus dem Stand der Technik sind beispielsweise selektive Metallabscheidungsprozesse bekannt; besonders geeignet ist jedoch die selektive Abscheidung einer isolierenden Schicht, vorzugsweise bei niedrigen Temperaturen. In der Europäischen Anmeldung Nr. EP-A-0 582 724 vom 4.8.92 ist ein entsprechendes Siliziumoxidabscheideverfahren beschrieben (evt. muß die Hilfsstruktur der vorliegenden Erfindung aus einem temperaturfesten Material hergestellt werden).Zwischen der Zellplatte und der Ätzmaske bzw. der Hilfsstruktur können Zwischenschichten vorhanden sein.

Die notwendige Topographie vor Herstellung der Ätzmaske - breite Abstände nur über zu kontaktierenden Gebieten - kann nicht nur durch das Layout der unteren Kondensatorplatte, sondern auch in Verbindung mit geeigneten anderen Maßnahmen erzeugt werden.

Die Erfindung wird nachfolgend anhand eines Ausführungsbeispiels, das in den Figuren dargestellt ist, weiter erläutert. Es zeigen:

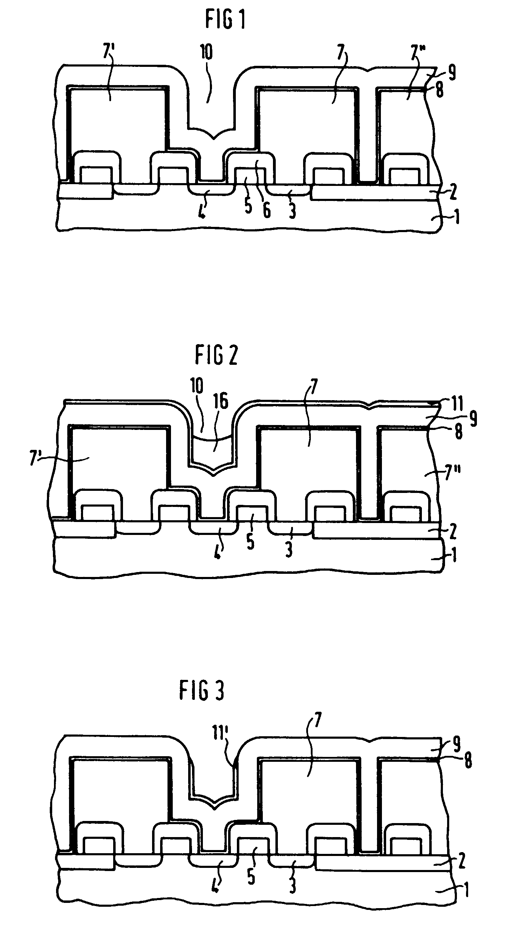

Figur 1 bis 6 einen Querschnitt durch ein Zellenfeld einer Halbleiterspeicheranordnung, an dem die Verfahrensschritte beispielhaft erläutert werden.

Figur 1: In bzw. auf einem Silizium-Halbleitersubstrat 1 ist ein Isolationsgebiet 2 und ein Transsistor erzeugt, der ein erstes S/D-Gebiet 3, ein zweites S/D-Gebiet 4 und ein Gate 5 umfaßt. Das Gate 5 ist durch ein nicht dargestelltes Gateoxid vom Halbleitersubstrat 1 isoliert und an den übrigen Oberflachen mit einer isolierenden Gateeinkapselung 6 versehen. Das erste S/D-Gebiet 3 ist mit einer unteren Kondensatorplatte 7 (Speicherelektrode) eines sogenannten Stacked Capacitor verbunden, die aus einer dotierten Polysiliziumschicht erzeugt ist. Zur Kapazitätserhöhung kann die untere Kondensatorplatte auch z. B. schüssel- oder kronenförmig ausgebildet sein.

Untere Kondensatorplatten 7, 7' benachbarter Speicherzellen, zwischen denen ein Bitleitungskontakt an das zweite S/D-Gebiet 4 hergestellt werden soll, müssen mit ausreichend großem Abstand gebildet werden. (In diesem Ausführungsbeispiel ist ein Bitleitungskontakt für diese beiden Speicherzellen vorgesehen, Entsprechendes gilt für Speicherzellen mit einem Bitleitungskontakt für jede Zelle.). An Stellen, an denen kein Kontakt zum Substrat 1 vorgesehen ist, werden die Kondensatorplatten 7, 7'' mit geringem Abstand voneinander hergestellt, vorzugsweise ist der Abstand so schmal, daß er durch die später herzustellende Zellplatte aufgefüllt wird.

Nach Herstellung der unteren Kondensatorplatte 7 wird ein Kondensatordielektrikum 8 mindestens auf der unteren Kondensatorplatte aufgebracht, vorzugsweise wird ganzflächig eine sogenannte ONO-Schicht hergestellt. Dann wird eine dotierte Polysiliziumschicht 9 für die Zellplatte abgeschieden, und zwar so dick, daß die schmalen Abstände im wesentlichen aufgefüllt werden, in den breiten Abständen - also nur über dem zweiten S/D-Gebiet - aber eine Vertiefung 10 bleibt.

Figur 2: Eine Siliziumnitridschicht 11 von etwa 10 - 30 nm Dicke wird auf der Zellplatte abgeschieden. Eine planarisierende Schicht, z. B. Fotolack, wird aufgebracht und ganzflächig rückgeätzt oder rückbelichtet, so daß nur in der nicht aufgefüllten Vertiefung 10 ein Lackstöpsel 16 verbleibt.

Figur 3: Selektiv zu dem Lackstöpsel wird das Nitrid 11 geätzt. Nach der Enternung des Lackstöpsels 16 bildet der unterliegende Teil der Nitridschicht 11 eine Hilfsstruktur 11'. Da die Nitridätzung vorzugsweise anisotrop durchgeführt wird, reicht das Nitrid 11' -unabhangig von der Gestalt des Lackstöpsels -bis zur Oberkante der Vertiefung 10. Dadurch ist ein weiter Prozeßspielraum bei der Herstellung des Stöpsels 16 gegeben.

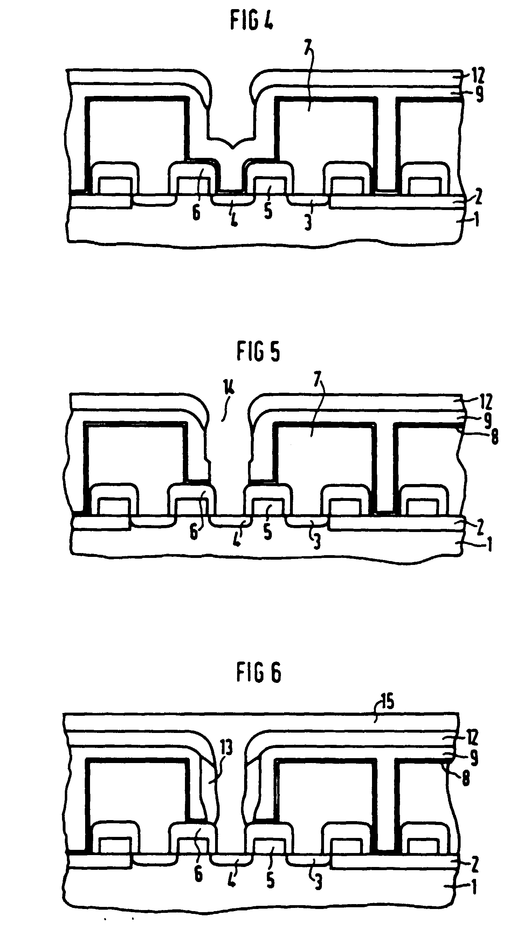

Figur 4: Selektiv zur Hilfsstruktur 11' wird auf der erhabenen Oberfläche der Zellplatte 9 eine Ätzmaske 12 erzeugt, beispielsweise durch einen Oxidationsprozeß. Die gesamte erhabene Oberfläche ist dann mit Siliziumoxid bedeckt, während darunter das nicht oxidierte dotierte Polysilizium als Zellplatte bleibt. Die Hilfsstruktur 11' wird vorzugsweise naß entfernt.

Figur 5: Die Polysiliziumschicht 9 wird unter Verwendung der Oxidmaske 12 anisotrop geätzt.

Das Kondensatordielektrikum 8 wird selektiv zur Gateeinkapselung 6 entfernt, so daß ein selbstjustiertes Bitleitungskontaktloch 14 entsteht.
Figur 6: Die freiliegende Flanke der Zellplatte 9 wird mit einer Flankenisolation 13 versehen, und zwar durch eine weitere Oxidation oder mit Hilfe eines Spacers. Das Kondensatordielektrikum 8 unter der Zellplatte wird entweder nach Ätzung der Zellplatte oder bei der Spacerätzung entfernt, in jedem Fall kann erreicht werden, daß die Gateeinkapselung 6 bei der Ätzung des Bitleitungskontaktlochs 14 nicht angegriffen wird.

Ebenfalls wird ein ggf. vorhandenes Feldoxid (außerhalb der Schnittebene) nicht angegriffen. Der Kontakt ist somit selbstjustiert zum Gate, zum Feldoxid, sowie zur oberen und unteren Zellplatte.

Die Speicheranordnung kann nun mit bekannten Verfahren (Herstellung einer Bitleitung 15 usw.) fertiggestellt werden.Die oxidierte Polysiliziumschicht 12 verbleibt als Isolationsschicht unter der Bitleitung 15.

## Patentansprüche

1. Herstellverfahren für ein Bitleitungskontaktloch einer Speicherzelle in einem Halbleitersubstrat (1) mit einem oberhalb eines MOS-Transistors (3, 4, 5) angeordneten Kondensator (7, 8, 9),
einer oberhalb des Kondensators angeordneten Bitleitung (15) und
einer unteren Kondensatorplatte (7), die mit einem ersten Source/Drain-Gebiet (3) des Transistors verbunden ist, wobei das Halbleitersubstrat mehrere Speicherzellen enthält, bei dem
- der Abstand der unteren Kondensatorplatten (7) benachbarter Speicherzellen über einem zu kontaktierenden zweiten Source/Drain-Gebiet (4) des Transistors breiter hergestellt wird als über dem übrigen Halbleitersubstrat (1),
- eine als Zellplatte dienende leitende Schicht (9) über den Kondensatorplatten in einer solchen Dicke aufgebracht wird, daß der schmale Abstand der Kondensatorplatten im wesentlichen aufgefüllt wird und in dem breiten Abstand eine Vertiefung (10) entsteht, so daß nach Aufbringen der leitenden Schicht (9) die Oberfläche Vertiefungen (10) über dem zweiten Source/Drain-Gebiet (4) aufweist und erhabene Stellen über den übrigen Bereichen der Speicherzelle,
- in der Vertiefung eine Hilfsstruktur (11') selbstjustiert zu der Vertiefung erzeugt wird,
- eine Maske (12) auf der nicht von der Hilfsstruktur bedeckten Oberfläche der leitenden Schicht (9) selbstjustiert zu der Hilfsstruktur erzeugt wird,
- das Bitleitungskontaktloch zu dem zweiten Source/Drain-Gebiet des Transistors unter Verwendung der Maske (12) geätzt wird, und
- eine Flankenisolation (13) mindestens an den im Bitleitungskontaktloch freiliegenden Stellen der leitenden Schicht (9) erzeugt wird.

2. Herstellverfahren nach Anspruch 1,
**dadurch gekennzeichnet,** daß zur Erzeugung der Hilfsstruktur (11') eine planarisierende Schicht ganzflächig aufgebracht und rückgeätzt oder rückbelichtet wird.

3. Herstellverfahren nach Anspruch 2,
**dadurch gekennzeichnet,**
daß vor Aufbringen der planarisierenden Schicht eine Hilfsschicht (11) ganzflächig aufgebracht wird.

4. Herstellverfahren nach einem der Ansprüche 1 bis 3,
**dadurch gekennzeichnet,**
daß die Maske (12) durch eine chemische Umwandlung der nicht von der Hilfsstruktur (11') bedeckten Oberfläche der leitenden Schicht (9) erzeugt wird.

5. Herstellverfahren nach einem der Ansprüche 1 bis 4,
**gekennzeichnet durch** folgende Schritte:
- Aufbringen eines Kondensatordielektrikums (8) auf das Halbleitersubstrat (1), die untere Kondensatorplatte (7) und ein mit einer Gateisolation (6) eingekapseltes Gate (5),
- Aufbringen von Polysilizium als leitende Schicht (9),
- ganzflächiges Aufbringen einer Nitridschicht (11) als Hilfsschicht auf der leitenden Schicht (9),
- Erzeugen von Lackstöpseln (16) in den Vertiefungen (10), Ätzen der Nitridschicht (11) selektiv zu den Lackstöpseln (12), und Entfernen der Lackstöpsel,
- Oxydation der freiliegenden Oberfläche der leitenden Schicht (9) zur Erzeugung einer selbstjustierten Maske (12) und Entfernen des restlichen Nitrids (11'),
- anisotropes Ätzen des freiliegenden Polysiliziums (9) unter Einsatz der Maske (12),
- Freilegen des zweiten Source/Drain-Gebietes durch Entfernen des Kondensatordielektrikums (8) selektiv zur Gateeinkapselung (6).

6. Herstellverfahren nach einem der Ansprüche 1 bis 5,
**dadurch gekennzeichnet,**
daß die Flankenisolation (13) durch einen Oxydationsprozeß erzeugt wird.

## Claims

1. Method of manufacturing a bit line contact hole of a memory cell in a semiconductor substrate (1) having a capacitor (7, 8, 9) which is arranged above a MOS transistor (3, 4, 5),
a bit line (15) which is arranged above the capacitor, and a lower capacitor plate (7) which is connected to a first source/drain region (3) of the transistor, the semiconductor substrate containing a plurality of memory cells, in which method
- the distance between the lower capacitor plates (7) of adjacent memory cells is manufactured so as to be greater over a second source/drain region (4) of the transistor with which contact is to be made than over the rest of the semiconductor substrate (1),
- a conductive layer (9) which serves as cell plate is applied over the capacitor plates to such a thickness that the narrow distance between the capacitor plates is essentially filled in and a depression (10) is produced in the wide gap so that, after the conductive layer (9) is applied, the surface has depressions (10) over the second source/drain region (4) and raised points over the other areas of the memory cell,
- an auxiliary structure (11') is produced in the depression, self-aligned with respect to the depression,
- a mask (12) is produced on the surface of the conductive layer (9) not covered by the auxiliary structure, self-aligned with respect to the auxiliary structure,
- the bit line contact hole is etched with respect to the second source/drain region of the transistor using the mask (12), and
- an edge insulation (13) is produced at least at the points of the conductive layer (9) exposed in the bit line contact hole.

2. Method of manufacturing according to Claim 1, characterized in that, in order to produce the auxiliary structure (11'), a planarizing layer is applied over the entire surface and is etched back or partly removed by exposure.

3. Method of manufacturing according to Claim 2, characterized in that, before the planarizing layer is applied, an auxiliary layer (11) is applied over the entire surface.

4. Method of manufacturing according to one of Claims 1 to 3, characterized in that the mask (12) is produced by means of a chemical conversion of the surface of the conductive layer (9) which is not covered by the auxiliary structure (11').

5. Method of manufacturing according to one of Claims 1 to 4, characterized by the following steps:
- application of a capacitor dielectric (8) to the semiconductor substrate (1), the lower capacitor plate (7) and a gate (5) which is encapsulated with a gate insulation (6),
- application of polysilicon as conductive layer (9),
- application over the entire surface of a nitride layer (11) as an auxiliary layer on the conductive layer (9),
- production of resist plugs (16) in the depressions (10), etching of the nitride layer (11) selectively with respect to the resist plugs (12), and removal of the resist plugs,
- oxidation of the exposed surface of the conductive layer (9) in order to produce a self-aligned mask (12) and removal of the remaining nitride (11'),
- anisotropic etching of the exposed polysilicon (9) using the mask (12),
- exposure of the second source/drain region by removing the capacitor dielectric (8) selectively with respect to the gate encapsulation (6).

6. Method of manufacturing according to one of Claims 1 to 5, characterized in that the edge insulation (13) is produced by means of an oxidation process.

## Revendications

1. Procédé de fabrication d'un trou de contact de ligne de transmission de bits d'une cellule de mémoire dans un substrat (1) en semi-conducteur, comportant un condensateur (7, 8, 9) monté au-dessus d'un transistor (3, 4, 5) MOS,
une ligne (5) de transmission de bits montée au-dessus du condensateur et
une plaque (7) de condensateur inférieure, qui est reliée à une première région (3) source/drain du transistor, le substrat en semi-conducteur comportant plusieurs cellules de mémoire, dans lequel
- on fait en sorte que l'intervalle entre des plaques (7) de condensateur inférieures de cellules de mémoire voisines soit plus grand au-dessus d'une deuxième région (4) source/drain à contacter du transistor qu'au-dessus du substrat (1) en semi-conducteur restant,
- on dépose au-dessus des plaques de condensateur une couche (9) conductrice servant de plaque de cellule en une épaisseur telle que l'intervalle petit entre les plaques de condensateur est sensiblement rempli et qu'il se forme sur le grand intervalle un renfoncement (10), si bien que, après le dépôt de la couche (9) conductrice, la surface comporte des renfoncements (10) au-dessus de la deuxième région (4) source/drain et des zones surélevées au-dessus des régions restantes de la cellule de mémoire,
- on produit dans le renfoncement une structure (11') auxiliaire de manière autoajustée par rapport au renfoncement,
- on produit de manière autoajustée par rapport à la structure auxiliaire un masque (12) à la surface de la couche (9) conductrice qui n'est pas couverte par la structure auxiliaire,
- on ménage par attaque chimique le trou de contact de ligne de transmission de bits par rapport à la deuxième région source/drain du transistor, en utilisant le masque (12) et
- on produit une isolation (13) de flanc au moins sur les emplacements de la couche (9) conductrice dégagée dans le trou de contact de transmission de bits.

2. Procédé de fabrication suivant la revendication 1, caractérisé en ce que, pour produire la structure (11') auxiliaire, on dépose sur toute la surface une couche de planarisation et on procède à son attaque chimique ou à son insolation par l'arrière.

3. Procédé de fabrication suivant la revendication 2, caractérisé en ce que, avant de déposer la couche de planarisation, on dépose sur toute la surface une couche (11) auxiliaire.

4. Procédé de fabrication suivant l'une des revendications 1 à 3, caractérisé en ce que l'on produit le masque (12) par une transformation chimique de la surface de la couche (9) conductrice qui n'est pas couverte par la structure (11') auxiliaire.

5. Procédé de fabrication suivant l'une des revendications 1 à 4, caractérisé par les étapes suivantes :
- on dépose un diélectrique (8) de condensateur sur le substrat (1) en semi-conducteur, sur la plaque (7) de condensateur inférieure et sur une grille (5) encapsulée par une isolation (6) de grille,
- on dépose du polysilicium comme couche (9) conductrice,
- on dépose sur toute la surface une couche (11) de nitrure comme couche auxiliaire sur la couche (9) conductrice,
- on produit des bouchons (16) de vernis dans les renfoncements (10), on procède à l'attaque chimique de la couche (11) de nitrure de manière sélective par rapport aux bouchons (16) de vernis et on élimine les bouchons de vernis,
- on oxyde la surface dégagée de la couche (9) conductrice pour produire un masque (12) autoajusté et on élimine le nitrure (11') restant,
- on procéde à l'attaque chimique anisotrope du polysilicium (9) dégagé en utilisant le masque (12)
- on dégage la deuxième région source/drain en enlevant le diélectrique (8) de condensateur de manière sélective par rapport à l'encapsulation (6) de grille.

6. Procédé de fabrication suivant l'une des revendications 1 à 5, caractérisé en ce que l'on produit l'isolation (13) de flanc par une opération d'oxydation.
